## Europäisches Patentamt

## European Patent Office

## Office européen des brevets

(19)

(11) Veröffentlichungsnummer: **0 021 139**
**B1**

(12) **EUROPÄISCHE PATENTSCHRIFT**

(45) Veröffentlichungstag der Patentschrift:
16.09.87

(51) Int. Cl.⁴: **H 01 L 21/60, H 01 L 23/48**

(21) Anmeldenummer: **80103076.8**

(22) Anmeldetag: **03.06.80**

(54) **Verfahren zur Herstellung einer Lötverbindung zwischen einer Halbleitereinrichtung und einem unterstützenden Substrat, sowie derart hergestellte Halbleiteranordnung.**

(30) Priorität: **29.06.79 US 53463**

(43) Veröffentlichungstag der Anmeldung:
**07.01.81 Patentblatt 81/1**

(45) Bekanntmachung des Hinweises auf die Patenterteilung:
**16.09.87 Patentblatt 87/38**

(84) Benannte Vertragsstaaten:
**DE FR GB**

(56) Entgegenhaltungen:
FR - A - 1 509 407
FR - A - 2 117 026
US - A - 3 401 055
US - A - 4 113 578

IBM TECHNICAL DISCLOSURE BULLETIN, Band 21, Nr. 3, August 1978, Seite 1007, New York, USA. D. K. JADUS: "Flip chip terminal for semiconductor devices"
IBM TECHNICAL DISCLOSURE BULLETIN, Band 20, Nr. 8, Januar 1978, Seiten 3080-3081, New York, USA. H. DALAL et al.: "Chrome-copper-chrome lift-off process"

(73) Patentinhaber: **International Business Machines Corporation, Old Orchard Road, Armonk, N.Y. 10504 (US)**

(72) Erfinder: **Carpenter, Charles, 178 North Clinton Street, Poughkeepsie, N.Y. 12601 (US)**
Erfinder: **Fugardi, Joseph F., 69 Edgehill Drive, Wappingers Falls, N..Y. 12590 (US)**
Erfinder: **Gregor, Lawrence V., Country Club Road, Hopewell Junction, N.Y. 12590 (US)**
Erfinder: **Grosewald, Peter Samuel, Mill Street, Putnam Valley, N.Y. (US)**
Erfinder: **Reeber, Morton D., 3508 Frost Road, Shrub Oak, N.Y. 10588 (US)**

(74) Vertreter: **Lewit, Leonard, Dipl.-Ing., IBM Deutschland GmbH Schönaicher Strasse 220, D-7030 Böblingen (DE)**

**Beschreibung**

Die Befestigung einer Halbleitereinrichtung auf einem Stütz-Substrat durch eine Lötverbindung muss verschiedenen Anforderungen genügen. Dazu gehört das Unterbinden einer thermisch bedingten Materialwanderung und eine Geschmeidigkeit gegenüber Spannungen, welche sich aus den verschiedenen Ausdehnungskoeffizienten der Materialien der Halbleitereinrichtung einerseits und dem Substrat andererseits ergeben.

Für integrierte Schaltungen müssen geeignete Anschlüsse zwischen den Schaltungen und anderen Schaltelementen oder Schaltungsstrukturen vorgesehen werden. Bei den integrierten Schaltungen kann es sich um einzelne aktive Einrichtungen, um einzelne passive Einrichtungen, um aktive Mehrfacheinrichtungen auf einem einzelnen Chip und um sowohl passive als auch aktive Mehrfacheinrichtungen auf einem einzelnen Chip handeln. Derartige Einrichtungen sind zumeist sehr klein und zerbrechlich. Deshalb werden sie auf einem unterstützenden Substrat aufgebracht. Die Aufbringung der Halbleitereinrichtungen auf das Substrat wirft jedoch eine Reihe schwieriger Probleme auf, da die entstehende Anordnung einer Reihe von Anforderungen genügen muss.

Bei einer solchen Aufbringung wird häufig die mechanische Verbindung durch Löten angewandt, die zugleich auch eine elektrische Verbindung ermöglicht. Diese Art der Verbindung erfüllt jedoch nicht die folgenden, der oben angesprochenen Anforderungen: Die Verbindung muss genügend Stabilität aufweisen, um die normalen Stoss- und Rüttelbeanspruchungen in einer Datenverarbeitungsanlage auffangen zu können. Ferner darf das Verbindungsmaterial sich nicht verschlechtern und auch nicht seine elektrischen oder mechanischen Eigenschaften ändern, wenn die Anordnung unter extremen Feuchtigkeits- oder Temperatur-Einflüssen geprüft wird. Ausserdem darf die verwendete Verbindung das Halbleitermaterial nicht kurzschliessen. Das Verbindungsmaterial muss also einen Schmelzpunkt aufweisen, der derart hoch liegt, dass es beim Anlöten des Substrats auf eine Schaltkarte nicht schmilzt. Schliesslich darf das Verbindungsmaterial auch keine Dotierung der Halbleitereinrichtungen auf dem Chip, das an das Substrat angelötet wird, verursachen.

Es sind bereits einige Einrichtungen bekannt geworden, welche geschmeidige Lötschichten verwenden, um Chips zu befestigen. Diese Einrichtungen gestatten es, die Übertragung von thermischen und mechanischen Beanspruchungen zur Verbindung zwischen den Schichten und den Halbleitereinrichtungen auf dem Chip zu verringern. Siehe hierzu die US-PS 3 495 133, sowie den Artikel «SLT Device Metallurgy and its Monolithic Extension» von P. TOTTA und R. SOPHER, in IBM Journal of Researche and Development, Vol. 13, No. 3, May 1969, Seiten 226 bis 238.

Aus der Patentschrift US-A-4 113 578 ist ein Lötkissen bekannt geworden, in dem auf dem Halbleitermaterial eine Chromschicht und darauf eine Kupferschicht aufgebracht wird. Das Aufbringen der Kupferschicht erfolgt bereits während noch Chrom aufgebracht wird, so dass während einer kurzen Zeit gleichzeitig beide Metalle aufgebracht werden und somit eine Zweiphasenschicht entsteht. Als oberste Schicht wird eine Goldschicht aufgebracht, die gut mit dem Lötmittel benetzbar ist.

In der Patentschrift FR-A-2 117 026 ist ein ähnliches Lötkissen beschrieben.

Die genannten Einrichtungen haben jedoch Nachteile, wenn hochintegrierte Halbleiteranordnungen mit hohem Leistungsverbrauch geschaffen werden sollen. Das hohe Ausmass von erzeugter Wärme kann von diesen Einrichtungen nicht aufgefangen werden, so dass sich ihre Eigenschaften unzulässig verschlechtern.

Der Erfindung, wie sie in den Ansprüchen gekennzeichnet ist, liegt daher die Aufgabe zugrunde, eine verbesserte Lötverbindung zwischen einer Halbleitereinrichtung und einem Stützsubstrat sowie ein diesbezügliches Herstellungsverfahren anzugeben, welche die oben genannten Nachteile nicht aufweisen.

Die Erfindung hat den Vorteil, dass die erfindungsgemässe Lötverbindung eine hohe Langzeitstabilität aufweist, selbst wenn sie hohen Beanspruchungen ausgesetzt wird. Bei diesen Beanspruchungen kann es sich sowohl um mechanische als auch um thermische Beanspruchungen handeln. Die erfindungsgemässen Lötschichten weisen eine hohe Nachgiebigkeit, bzw. Geschmeidigkeit auf und gestatten es hierdurch, die durch verschiedene thermische Ausdehnungskoeffizienten der Materialien entstehenden Spannungen aufzufangen. Die erfindungsgemässe Sperrschicht schützt die Schicht hoher Leitfähigkeit, da unerwünschte Einflüsse umgebender Schichten ausgeschaltet werden. Die Verbindung ist auch widerstandsfähig gegen Feuchtigkeitseinwirkungen, weist einen hohen Schmelzpunkt auf und vermeidet eine unbeabsichtigte Dotierung der umgebenden Halbleitereinrichtungen. Ausserdem gestattet sie die einfache Herstellung von leitenden Verbindungen zu den umgebenden Schaltungsanordnungen.

Ein Ausführungsbeispiel der Erfindung soll nun anhand von Figuren beschrieben werden.
Es zeigen:
Fig. 1 ein Flussdiagramm zur Beschreibung der einzelnen Schritte des erfindungsgemässen Herstellungsverfahrens und

Fig. 2 eine Halbleiteranordnung mit dem erfindungsgemässen Lötschichtkissen.

Zum besseren Verständnis der vorliegenden Erfindung soll zuerst die Wärmeableitung in einer Halbleiteranordnung der betrachteten Art anhand von zwei bekannten Einrichtungen beschrieben werden. In gelöteten hochintegrierten Halbleitereinrichtungen wird die während des Betriebes der Halbleitereinrichtung entwickelte Wärme grösstenteils über die Lötverbindung zum Substrat abgeleitet. Dies ist sogar der Fall, wenn die Einrichtungen in eine Kühlflüssigkeit eingebracht sind, wie es die US-PS 3 741 292 beschreibt, oder wenn die entwickelte Wärme von der Rückseite der Einrichtung durch Leitungsstrukturen abgeleitet wird, wie es die Kühleinrichtung nach der US-PS 3 993 123 beschreibt. Der Wärmefluss durch die Verbindung erzeugt thermische Gradienten in der Lötverbindung, welche zur thermischen Wanderung von Lötatomen in der Lötverbindung führen. Der Materialfluss J kann durch die folgende Gleichung ausgedrückt werden:

$$J \sim D\Delta E \frac{\Delta T}{T^2} ,$$

worin D die Diffusionskonstante, E den Energietherm, der mit der Wärmeentwicklung des Transportes und der Enthalpy (Wärmeinhalt) der Bildung einer Fehlstelle verbunden ist, und T die Temperatur in Grad Kelvin darstellen. Die Richtung der Wanderung von Lötmittelatomen in einer Lötverbindung, die einem thermischen Gradient unterliegt, ist von der Halbleitereinrichtung, d.h. von der Wärmequelle, zum kühleren Substrat gerichtet, während Fehlstellen zur Halbleitereinrichtung diffundieren. Die radiale Komponente des thermischen Gradients, welche durch die Zusammenziehung der Lötverbindung bei der Bewegung durch die Durchverbindungsöffnung in der Glasschicht entsteht, konzentriert die Fehlstellen in das Zentrum der Durchverbindungsöffnung bei der Kugelbegrenzungs-Metallurgy. Dies führt zu einer Unterbrechung des Verbindungsgefüges und zu einer allmählichen Zunahme des elektrischen Widerstandes der Zusammenfügung, besonders bei Verwendung der Einrichtung unter hoher Belastung.

Es ist festgestellt worden, dass die verschiedenen Lötmitteltypen, welche in Lötverbindungen verwendet werden, unterschiedliche Geschwindigkeiten bei der Bildung von Fehlstellen in der Lötverbindung aufweisen. Die Auswahl des Lötmittels kann jedoch durch praktische Überlegungen begrenzt sein. Halbleitereinrichtungen sind normalerweise aus Silicium aufgebaut, das einen Ausdehnungskoeffizient von $3 \cdot 10^{-6}/°K$ aufweist. Das unterstützende Substrat wird normalerweise aus keramischem Material gebildet, das einen Ausdehnungskoeffizient im Bereich von 4,8 bis $6,8 \cdot 10^{-6}/°K$ hat. Diese Differenz im Ausdehnungskoeffizient resultiert in einer mechanischen Belastung der Lötverbindung während der Herstellung und während des Betriebes, wenn die Temperatur der Anordnung Schwankungen unterliegt. Es ist erwünscht, dass das verwendete Lötmittel eine genügend hohe Geschmeidigkeit aufweist, um, zumindest teilweise, die aus den Temperaturschwankungen resultierenden mechanischen Beanspruchungen auffangen zu können. Bei einem Lötmittel der betrachteten Art wird angestrebt, dass es einen hohen Prozentsatz von Indium aufweist. Unglücklicherweise zeigt jedoch Indium ein hohes Ausmass von thermischer Wanderung während des Betriebes.

Die nach der Erfindung verwendete verbesserte Lötverbindung soll daher eine relativ dicke Kupferschicht in dem zur Durchführung der Lötverbindung verwendeten Kugelbegrenzungs-Metallurgieschichtblock aufweisen. Da Kupfer ein ausgezeichneter Wärmeleiter ist, wird somit der radiale thermische Gradient in der Durchverbindung vermindert. Infolgedessen wird auch die treibende Kraft für die thermische Wanderung, die die Fehlstellen im Zentrum der Metallurgieschicht konzentrieren, vermindert und die erreichte Lötdurchverbindung verändert ihre Eigenschaften während des Betriebes nicht wesentlich.

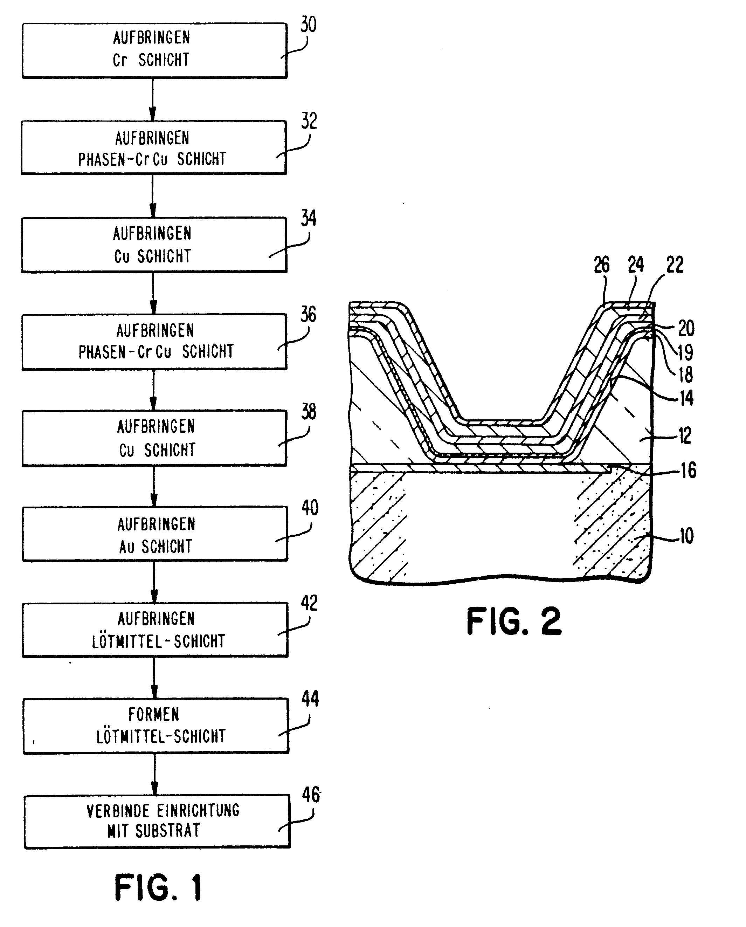

In Fig. 2 ist eine bevorzugte Form des erfindungsgemässen Kugelbegrenzungs-Metallurgieschichtblocks gezeigt. Der Schichtblock besteht aus einem Kissen von übereinander angeordneten metallurgischen Schichten und verhindert ein seitliches Abfliessen der Lötkugel. Das Substrat 10 ist mit einer isolierenden Schicht 12 aus $SiO_2$ bedeckt, die eine Durchgangsverbindung 14 aufweist, welche die Schicht 12 durchbricht und elektrischen Kontakt zu einem Diffusionsgebiet 16 herstellt. Die Einrichtung weist normalerweise mehrere Metallurgielagen auf, welche in einem Gesamtmetallurgiesystem die verschiedenen aktiven und passiven Elemente zu der gewünschten Schaltung verbinden.

Fig. 2 stellt eine einfache Struktur zum Zwecke der Erläuterung dar. In der gezeigten Methode wird eine Schicht 18 aus Chrom auf die Oberfläche der Schicht 12 gebracht, vorzugsweise durch Vakuumverdampfung. Dieser Verfahrensschritt ist in dem in Fig. 1 gezeigten Herstellungsverfahren durch den Block 30 dargestellt. Hierauf wird phasenmässig, d.h. in bestimmter zeitlicher Abstimmung eine Kupfer-Chrom-Zweiphasenschicht 19 auf die Schicht 18 in nachfolgend beschriebener Weise aufgebracht. Dieser Verfahrensschritt ist in Fig. 1 durch den Block 32 dargestellt. Nachfolgend wird eine Kupferschicht 20 auf die Schicht 19 durch Vakuumverdampfung aufgebracht. Dieser Schritt ist in Fig. 1 durch den Block 34 dargestellt. Eine phasenmässige Kupfer-Chrom-Zweiphasenschicht 22 wird auf die Schicht 20 aufgebracht, wie durch den Block 36 dargestellt ist. Diese phasenmässig aufgebrachte Schicht besteht aus einer Kombination von Kupfer und Chrom. Wenn eine Vakuumverdampfung zur Aufbringung der verschiedenen Metalle verwendet wird, bleibt die Erhitzung der Kupferquelle eingeschaltet, während die Erhitzung des Chroms eingeschaltet wird. Darauffolgend wird die Erhitzung des Kupfers abgeschaltet. Auf diese Weise werden Chrom und Kupfer zugleich während eines gewissen Zeitintervalles aufgebracht, und hierdurch eine sogenannte Zweiphasenschicht erzeugt, während hierauf nur eine reine Kupferschicht aufgebracht wird. Dieser Schritt ist in Fig. 1 durch den Block 38 dargestellt. Schliesslich wird eine dünne Goldlage aufgedampft, um das Metallurgiegebilde zu schützen. Dieser Schritt ist in Fig. 1 durch den Block 40 dargestellt. Gebräuchlicherweise werden die Schichten 18 bis 26 als Mantelschichten aufgebracht. Nach der letzten Schicht wird auf der Oberfläche eine Deckschicht gebildet, die mit dem gewünschten Muster exponiert und hierauf entwikkelt wird. Die Aussenteile des Kugelbegrenzungs-Metallurgieschichtblocks erstrecken sich über den Durchmesser der Durchgangsverbindung 14 hinaus. Geeignete Ätzlösungen können dazu verwendet werden, die exponierten Bereiche der Schichten 18 bis 26 zu entfernen, um den Kugelbegrenzungs-Metallurgieschichtblock zu definieren.

Eine relativ dicke Schicht eines Lötmittels wird auf den Metallurgieschichtblock, vorzugsweise durch Verdampfung durch eine Metallmaske mit Öffnungen über der Schichtstruktur selbst und über dem umgebenden Gebiet, aufgebracht. Dieser Schritt ist in Fig. 1 mit dem Block 42 angegeben. Die aufgebrachte Lötmittellage wird dann durch Erhitzung geformt, wobei die Oberflächenspannung das Lötmittel von den nichtbenetzbaren $SiO_2$-Oberflächenbereichen wegbringt. Da die oberste Lage des Kugelbegrenzungs-Metallurgieschichtblocks mit Lötmittel benetzbar ist und dies für die oberste Lage der Schicht 12 nicht zutrifft, formt sich das Lötmittel über der Schichtstruktur zu einer Kugel mit begrenztem Durchmesser, wenn eine Erhitzung durchgeführt wird. Die Schichtstruktur wirkt also lötkugelbegrenzend. Dieser Schritt ist in Fig. 1 mit dem Block 44 angegeben. Die Halbleiter-Einrichtung wird hierauf über dem Substrat, das eine Reihe von mit Lötmittel benetzbaren Schichtblöcken, entsprechend der Konfiguration der Schichten auf der Halbleitereinrichtung, aufweist, positioniert und diese zusammengefügte Anordnung erhitzt. Das Lötmittel an der Grenzschicht schmilzt hierdurch und verbindet elektrisch die Schichten auf der Halbleitereinrichtung und dem Substrat. Dieser Schritt ist in Fig. 1 mit dem Block 46 bezeichnet. Während des Formierungsschrittes 44 und des Zusammenfügungsschrittes 46 vereinigt sich das Lötmittel mit der Goldlage 26 und der Kupferlage 24 und bildet ein intermetallisches Gemisch, das im Lötmittel verbleibt. Die phasenmässig erzeugte Chrom-Kupfer-Zweiphasenschicht 22 löst sich jedoch nicht im verflüssigten Lötmittel während der zuvor genannten Verfahrensschritte auf, sondern bleibt Lötmittelbenetzbar. Diese Schicht 22 dient als Trennschicht zwischen dem geschmolzenen Lötmittel und der Kupferlage 20. Die Integrität der Lage 20 wird somit durch die phasenmässig hergestellte Chrom-Kupfer-Zweiphasenschicht 22 aufrechterhalten. Die Kupferschicht 20 dient während des Betriebes der Anordnung als Wärmeableitungsschicht und setzt hierdurch die thermischen Gradienten im Lötmittel und auch die thermische Materialwanderung herab, welche sonst den Widerstand der Lötverbindung erhöhen und schliesslich eine Unterbrechung erzeugen würden. Es wurde festgestellt, dass ein Blei-Indium-Lötmittel mit vorzugsweise 50% Blei und 50% Indium genügend geschmeidig ist, um mechanische Beanspruchungen durch die unterschiedlichen Ausdehnungskoeffizienten der Halbleitereinrichtung und des Substrates während normaler Temperaturveränderungen auffangen zu können. Dieses Lötmittel weist jedoch andererseits eine höhere thermische Wanderung durch die thermischen Gradienten in der Lötzusammenfügung auf.

In der Kugelbegrenzungs-Metallurgie-Schichtstruktur weist die Schicht 18 eine Dicke von 50 nm bis 150 nm auf. Die Schichten 19 und 22, welche phasenmässig hergestellte Chrom-Kupfer-Zweiphasenschichten sind, können eine geeignete Dicke aufweisen, die vorzugsweise im Bereich von 50 nm bis 150 nm liegt. Die Kupferlage 24 weist eine Dicke von 200 nm bis 500 nm auf, während die Kupferschicht 20 eine Dicke von 500 nm bis 1000 nm aufweist.

Es soll daraufhingewiesen werden, dass die phasenmässig aufgebrachte Kupfer-Chrom-Zweiphasenschicht zwischen einigen oder allen Lagen hergestellt werden kann.

Nachfolgend werden Beispiele gebracht, um die Praxis der erfindungsgemässen Methode zu zeigen und um den erzielten Anschluss mit bekannten Einrichtungsanschlüssen zu vergleichen.

Beispiel I (herkömmliche Art)

Es wurden Halbleiterchips hergestellt, um Lötverbindungen unter beschleunigter Prüfung testen zu können. Es wurde ein Siliciumplättchen einer ersten Leitfähigkeitstype hergestellt, in das eine Anzahl von Diffusionsgebieten der umgekehrten Leitfähigkeitstype eingebracht wurden. Auf die Oberfläche wurde eine Passivierungsschicht vom Siliciumoxid aufgebracht, und darin Durchverbindungslöcher geätzt mit einem mittleren Durchmesser von 75 Mikrometer. In jedem dieser Testchips wurden vier Durchverbindungsöffnungen zu jedem Diffusionsgebiet gebildet. Das Diffusionsgebiet wurde als Widerstand benutzt und an die Endanschlüsse wurde Spannung angelegt, um die Anordnung aufzuwärmen. Zu den dazwischenliegenden Durchverbindungslöchern wurden Lötanschlüsse gemacht, um Widerstandsänderungen zum beschleunigten Testen feststellen zu können. Zu Vergleichszwecken wurden gebräuchliche Kugelbegrenzungs-Metallurgieschichtblöcke herangezogen und ebenfalls getestet.

Diese herkömmlichen Kugelbegrenzungs-Metallurgieschichten wurden durch Aufdampfen einer Chromschicht mit einem Durchmesser von 125 µm und einer Dicke von 150 nm konzentrisch auf die Durchverbindungsöffnungen, welche in die Passivierungsschicht geätzt wurden, erzeugt. Eine phasenmässig aufgebrachte Chrom-Kupfer-Zweiphasenschicht, mit einer Dicke von 100 nm, wurde auf die Chromschicht aufgebracht und darauf wurde eine Kupferschicht, mit einer Dicke von 500 nm, aufgebracht. Darauf wurde ein Goldüberzug mit einer Dicke von ungefähr 120 nm aufgebracht. Auf den Kugelbegrenzungsschichtblock wurde eine Schicht eines Lötmittels mit 50% Blei und 50% Indium und einer Dicke von ungefähr 125 µm aufgebracht und hieraus Lötanschlussflächen geformt. Die Scheibe wurde zerschnitten, wodurch die Diffusionsgebiete voneinander getrennt wurden und als Testeinrichtung benutzt werden konnten. Mehrere der Lötkügelchen wurden vom Chip abgezogen, wobei sich zeigte, dass durch die Geschmeidigkeit des Lötmittels die Kugeln sich beim Abziehen erst verlängerten, bevor sie losgerissen wurden. Dabei wurde eine zerrissene Oberfläche auf dem gesamten Gebiet des Schichtblocks beobachtet, das anzeigte, dass die Haftung ziemlich gleichförmig war über die gesamte Durchverbindungsöffnung und das umgebende Schichtkissen. Der ursprüngliche elektrische Widerstand zwischen den Anschlüssen wurde gemessen und ein Wert von 8 bis 9 Milliohm festgestellt. Die Verbindungen mit den höchsten Widerstandswerten wurden zur andauernden Überwachung ausgewählt. An die Anordnungen wurde sodann eine derartige Spannung angelegt, dass eine Leistung von ungefähr 12 Watt pro Chip verbraucht wurde, was ein abnormal hoher Leistungsverbrauch ist und eine beschleunigte Prüfung gestattet. Nach 14 Stunden hatte sich der mittlere Widerstand zwischen den Anschlüssen der überwachten Lötverbindungen um 10 Milliohm erhöht. Dies wurde als Standard-Vergleichswert angenommen. Die Lötkügelchen wurden sodann auseinandergeteilt. Dabei wurde beobachtet, dass die Teilung im Zentrum der Kugeln glatt erfolgte, während an den äusseren Gebieten eine zerrissene Teilungsoberfläche festgestellt wurde. Dies deutete darauf hin, dass eine Materialtrennung im Zentrum der Verbindung in der Durchgangsverbindungsöffnung stattgefunden hatte, die vor dem Testdurchlauf nicht vorhanden war.

Beispiel II (gemäss vorliegender Erfindung)

Es wurde ein zweiter Satz von Chips, wie im Beispiel I besprochen hergestellt, wobei der erfindungsgemässe Lötanschluss-Metallurgieschichtblock verwendet wurde. Die Lötanschlüsse wurden über Durchverbindungsöffnungen geformt, die ebenfalls einen Durchmesser von 75 µm hatten, indem eine Chromschicht mit einer Dicke von 50 nm aufgebracht wurde. Hierauf folgte eine phasenmässig erzeugte Chrom-Kupfer-Zweiphasenschicht mit einer Dicke von 100 nm, eine Kupferschicht mit einer Dicke von 1000 nm, eine zweite phasenmässig erzeugte Chrom-Kupfer-Zweiphasenschicht mit einer Dicke von 100 nm, eine Kupferschicht mit einer Dicke von 500 nm und eine Goldschicht mit einer Dicke von 120 nm. Eine Lötschicht von 50% Blei und 50% Indium, mit einer Dicke von 75 µm wurde über die Kugelbegrenzungs-Metallurgieflächen aufgebracht. Das Lötmittel wurde wie in Beispiel I geformt, und mehrere Lötkugeln wurden von dem Schichtblock abgezogen. Wieder wurde festgestellt, dass, wie im Beispiel I, die gesamte Oberfläche des Schichtblocks zerrissen war, was auf eine gleichmässige Adhäsion über die gesamte Fläche der Durchverbindungsöffnung hinwies. Die Testchips wurden hierauf auf ein Substrat aufgebracht und mit 12 Watt pro Chip, wie im Beispiel I, aufgeheizt. Der Widerstand der Lötanschlüsse, die nach der vorliegenden Erfindung geformt worden waren, wurde gemessen, wobei ein mittlerer Widerstand von 8 bis 9 Milliohm festgestellt wurde. Nach einer Aufheizung der Chips während 3 Stunden wurde der Widerstand der Anschlüsse gemessen und keine messbare Änderung im Widerstandswert festgestellt. Die Testchips wurden weiterhin mit 12 Watt betrieben und der Widerstand periodisch gemessen. Nach 63 Stunden zeigte die schlechteste Lötverbindung eine Widerstandserhöhung von 10 Milliohm. Die mittlere Widerstandserhöhung betrug nur 2,3 Milliohm. Die Änderung des Widerstandswertes über die Zeit wurde aufgenommen und aus dem Verlauf dieser Kurve wurde für eine mittlere Lötverbindung eine Zeit festgestellt, nach der die Widerstandserhöhung 10 Milliohm betrug. Dieser voraussichtliche Zeitwert wurde mit 279 Stunden festgestellt. Mehrere Lötanschlüsse wurden von den Testeinrichtungen nach Beendigung der Heizperiode losgerissen und die Oberfläche untersucht. Nach 63 Stunden wurde keine feststellbare Glättung der getrennten Oberflächen im Zentrum der Durchverbindungsöffnung festgestellt. Die beschleunigte Prüfung wurde fortgesetzt. Nach 93 Stunden wurde ein mittlerer Widerstands-Erhöhungswert der Lötverbindung von 3,3 Milliohm festgestellt. Ein Vergleich der Resultate von Beispiel I, in dem herkömmliche Lötverbindungen mit einer Kugelbegrenzungs-Metallurgie-Schichtkissenstruktur mit einer Chrom-Kupfer-Goldkugel verwendet wurden, und dem Beispiel II, worin das erfindungsgemässe Metallurgie-Schichtkissen verwendet wurde, zeigte an, dass die Lötverbindungen nach der Erfindung den bekannten Lötverbindungen weitaus überlegen war.

## Patentansprüche

1. Verfahren zur Herstellung einer Lötverbindung zwischen einer Halbleitereinrichtung und einem Halbleitersubstrat unter Verwendung eines lötmittelbenetzbaren Schichtkissens, das aus einer Vielzahl von aufeinander aufgebrachten, metallurgischen Schichten besteht, wobei auf die Oberfläche der Halbleitereinrichtung zuerst eine Chromschicht (18) und dann eine Kupferschicht (20) aufgebracht wird und wobei sich das Aufbringen beider Metalle während einer vorher bestimmten Zeit überlappt und dadurch eine erste Chrom-Kupfer-Zweiphasenschicht (19) entsteht, gekennzeichnet durch die folgenden, nach dem Aufbringen der ersten Kupferschicht (20) durchgeführten Schritte:

a) Aufbringen einer zweiten Chrom-Kupfer-Zweiphasenschicht (22) auf die erste Kupferschicht (20),

b) Aufbringen einer zweiten Kupferschicht (24), auf die zweite Chrom-Kupfer-Zweiphasenschicht (22),

c) Aufbringen einer dicken Lage eines Lötmittels auf das durch die vorhergehenden Schritte geformte Schichtkissen,

d) Positionieren der Halbleitereinrichtung über dem Substrat (10), das ein entsprechendes lötmittelbenetzbares Schichtkissen aufweist, und

e) Erhitzen der Anordnung zum Verbinden der Schichtstruktur auf der Halbleitereinrichtung mit der Schichtstruktur auf dem Substrat.

2. Verfahren nach Anspruch 1, dadurch gekennzeichnet, dass das Lötmittel einen beträchtlichen Anteil von Indium enthält.

3. Verfahren nach Anspruch 2, dadurch gekennzeichnet, dass das Lötmittel aus einem Gemisch von Indium und Blei besteht.

4. Verfahren nach Anspruch 3, dadurch gekennzeichnet, dass das Lötmittel 50% Indium und 50% Blei enthält.

5. Verfahren nach Anspruch 1, dadurch gekennzeichnet, dass die Dicke des Lötmittels zwischen 50 und 150 µm liegt.

6. Verfahren nach Anspruch 1, dadurch gekennzeichnet, dass auf die zweite Kupferschicht (24) eine Schutzschicht (26) aus Gold aufgebracht wird.

7. Lötverbindung mit einem lötkugelbegrenzenden Kissen aus metallurgischen Schichten zur Verbindung von Halbleitereinrichtungen, mit einer ersten, auf dem Halbleiter aufgebrachten Chromschicht (18) und einer darauf aufgebrachten ersten Kupferschicht (20), wobei sich das Aufbringen beider Metalle während einer vorher bestimmten Zeit überlappt und dadurch eine erste Chrom-Kupfer-Zweiphasenschicht (19) entsteht, gekennzeichnet durch folgende, aufeinanderliegende Schichten:
- eine zweite Chrom-Kupfer-Zweiphasenschicht (22) auf der ersten Kupferschicht (20),
- eine zweite Kupferschicht (24) auf der zweiten Chrom-Kupfer-Zweiphasenschicht, und
- eine oberflächlich angeordnete Goldschicht (26).

## Claims

1. Method of making a solder interconnection between a semiconductor device and a semiconductor substrate using a solder wettable pad structure consisting of a multitude of superimposed metallurgy layers, with a chromium layer (12) and a copper layer (20) being first deposited on the surface of the semiconductor device, and with the deposition of both metals overlapping during a predetermined period and thus forming a first chromium-copper two-phase layer (19), characterized by the following steps implemented subsequent to the deposition of the first copper layer (20):
a) deposition of a second chromium-copper two-phase layer (22) on the first copper layer (20),
b) deposition of a second copper layer (24) on the second chromium-copper two-phase layer (22),
c) deposition of a thick layer of solder over the pad structure formed by the preceding steps,
d) positioning of the semiconductor device over the substrate (10) which comprises a corresponding solder wettable pad structure, and
e) heating the arrangement to join the pad structure of the semiconductor device to the pad structure of the substrate.

2. Method as claimed in claim 1, characterized in that the solder includes a significant amount of indium.

3. Method as claimed in claim 2, characterized in that the solder consists of a mixture of indium and lead.

4. Method as claimed in claim 3, characterized in that the solder contains 50% indium and 50% lead.

5. Method as claimed in claim 1, characterized in that the thickness of the solder varies between 50 and 150 µm.

6. Method as claimed in claim 1, characterized in that onto the second copper layer (24) a protective layer (26) of gold is applied.

7. Solder interconnection comprising a solder ball limiting metallurgy layer pad structure for connecting semiconductor devices, comprising a first chromium layer (18) deposited on the semiconductor and a first copper layer (20) deposited thereon, with the deposition of both metals overlapping during a predetermined period of time, thus forming a first chromium-copper two-phase layer (19), characterized by the following superimposed layers:
- a second chromium-copper two-phase layer (22) on the first copper layer (20),
- a second copper layer (24) on the second chromium-copper two-phase layer, and
- a surface-covering gold layer (26).

## Revendications

1. Procédé pour l'établissement d'une connexion brasée entre un dispositif semiconducteur et un substrat semiconducteur, en utilisant un coussin multi-couches mouillable par une brasure et constitué par une pluralité de couches métallurgiques superposées, une couche de chrôme (12) étant déposée d'abord sur la surface du dispositif semiconducteur et ensuite une couche de cuivre (20), les dépôts des deux métaux se chevauchant pendant une durée prédéterminée, produisant ainsi une première couche bi-phasique chrôme-cuivre (19), procédé caractérisé par les étapes suivantes, mises en œuvre après le dépôt de la première couche de cuivre (20):
a) dépôt, sur la première couche de cuivre (20), d'une deuxième couche bi-phasique chrôme-cuivre (22),
b) dépôt sur la deuxième couche bi-phasique chrôme-cuivre (22), d'une deuxième couche de cuivre (24),
c) dépôt sur le coussin multi-couches constitué par les étapes précédentes, d'une couche épaisse de brasure,
d) positionnement du dispositif semiconducteur au-dessus du substrat (10), qui présente un coussin multi-couches correspondant, mouillable par la brasure, et
e) chauffage de l'ensemble pour lier la structure multi-couches sur le dispositif semiconducteur, avec la structure multi-couches sur le substrat.

2. Procédé selon la revendication 1, caractérisé en ce que la brasure contient une proportion importante d'indium.

3. Procédé selon la revendication 2, caractérisé en ce que la brasure est constituée par un mélange d'indium et de plomb.

4. Procédé selon la revendication 3, caractérisé en ce que la brasure contient 50% d'indium et 50% de plomb.

5. Procédé selon la revendication 1, caractérisé en ce que l'épaisseur de brasure se situe entre 50 et 100 μ.

6. Procédé selon la revendication 1, caractérisé en ce que la deuxième couche de cuivre (24) est revêtue d'une couche de protection (26) en or.

7. Connexion brasée avec un coussin de délimitation de bille de brasure, constitué par des couches métallurgiques, pour relier des dispositifs semiconducteurs, avec une première couche de chrôme (18) déposée sur le semiconducteur et une première couche de cuivre (20) déposée sur la couche précédente, le dépôt des deux métaux s'effectuant à chevauchement pendant une durée prédéterminée et une première couche bi-phasique chrôme-cuivre (19) étant ainsi obtenue, connexion caractérisée par les couches superposées suivantes:

– une deuxième couche bi-phasique chrôme-cuivre (22) sur la première couche de cuivre (20),

– une deuxième couche de cuivre (24) sur la deuxième couche bi-phasique chrôme-cuivre, et

– une couche d'or (26) disposée en surface.

| AUFBRINGEN Cr SCHICHT | 30 |

↓

| AUFBRINGEN PHASEN-CrCu SCHICHT | 32 |

↓

| AUFBRINGEN Cu SCHICHT | 34 |

↓

| AUFBRINGEN PHASEN-CrCu SCHICHT | 36 |

↓

| AUFBRINGEN Cu SCHICHT | 38 |

↓

| AUFBRINGEN Au SCHICHT | 40 |

↓

| AUFBRINGEN LÖTMITTEL-SCHICHT | 42 |

↓

| FORMEN LÖTMITTEL-SCHICHT | 44 |

↓

| VERBINDE EINRICHTUNG MIT SUBSTRAT | 46 |

FIG. 1

FIG. 2